# FASCICULE DE BREVET EUROPEEN

(11) **EP 2 266 205 B1**
(45) Date de publication et mention de la délivrance du brevet: **04.01.2012**
(21) Numéro de dépôt: 09738334.3
(22) Date de dépôt: 10.04.2009
(51) Int. Cl.: H03K 3/57

(54) **GENERATEUR D'IMPULSIONS ELECTRIQUES DE FORTE PUISSANCE A SPECTRE EVOLUTIF, INSTALLATION ET EQUIPEMENT METTANT EN OEUVRE UN TEL GENERATEUR**
HOCHLEISTUNGS-STROMIMPULSGENERATOR MIT VARIABLEM SPEKTRUM SOWIE ANLAGE UND AUSRÜSTUNG ZUM BETRIEB EINES SOLCHEN GENERATORS
VARIABLE-SPECTRUM HIGH-POWER ELECTRICAL PULSE GENERATOR, AND FACILITY AND EQUIPMENT OPERATING SUCH A GENERATOR

(30) Priorité: 11.04.2008 FR 0852444
(43) Date de publication de la demande: 29.12.2010
(73) Titulaire: Université de Limoges, 87032 Limoges (FR); Centre National de la Recherche Scientifique - CNRS, 75794 Paris Cedex 16 (FR); Institut Franco-Allemand de Recherches de Saint-Louis, 68301 Saint-Louis Cedex (FR)
(72) Inventeur: COUDERC, Vincent, F-87430 Verneuil-sur-Vienne (FR); VERGNE, Bertrand, F-68100 Mulhouse (FR); LEVEQUE, Philippe, F-87350 Panazol (FR)
(74) Mandataire: Novagraaf Technologies
(86) Numéro de dépôt international: PCT/FR2009/000421
(87) Numéro de publication internationale: WO 2009/133300

(56) Documents cités:
- FR-A- 2 895 847
- US-A- 3 703 661
- US-A- 4 782 222

## Description

La présente invention concerne un générateur d'impulsions électriques de forte puissance à spectre évolutif, ainsi qu'une installation et un équipement mettant en oeuvre un tel générateur.

### DOMAINE TECHNIQUE

La présente invention se rapporte au domaine des générateurs d'impulsions électriques de forte puissance.

Elle se rapporte plus particulièrement à un générateur d'impulsions haute tension comprenant un système de génération d'impulsions haute tension à ondes gelées et un système de déclenchement desdites impulsions, ledit système de génération comprenant un premier et un second éléments photoconducteurs.

### ÉTAT DE LA TECHNIQUE ANTERIEURE

Un tel générateur vise à être utilisé dans des applications où il est nécessaire d'émettre des impulsions électriques de forte puissance (plusieurs kilovolts) et de courte durée (de l'ordre de la nanoseconde ou en dessus). Il importe également qu'il soit apte à être synchronisé avec d'autres systèmes électriques ou optiques.

L'état de la technique comporte des générateurs d'impulsions purement électroniques. Ces générateurs permettent d'engendrer des impulsions électriques de forte puissance avec des durées comprises entre quelques picosecondes et plusieurs millisecondes. Néanmoins, ces générateurs ne sont pas parfaitement synchronisables entre eux et ne permettent également pas de contrôler le contenu spectral de l'impulsion de sortie.

Afin d'obtenir des impulsions électriques de forte puissance et de courte durée - typiquement de l'ordre de la nanoseconde ou en dessous -, il est connu d'utiliser des générateurs à commutation optoélectronique, dits à ondes gelées. Ces générateurs utilisent des substrats semiconducteurs de nature diverse.

Plusieurs modes de commutation sont connus parmi lesquels un mode dit « avalanche » et un mode dit « linéaire ».

Un générateur utilisant un régime de commutation en avalanche est décrit dans le document de brevet US 4,782,222. Ce générateur comprend un bloc de substrat semiconducteur, deux éléments conducteurs couplés audit bloc et séparés d'une distance déterminée, une alimentation haute tension disposée entre les deux éléments conducteurs ainsi que des moyens d'illumination dudit bloc à une longueur d'onde donnée de sorte à ce que la majorité de la lumière pénètre à travers ledit bloc sur une distance inférieure à la distance entre lesdits deux éléments conducteurs. Un tel système permet de réaliser des commutations très haute tension en ne nécessitant que peu d'énergie optique.

Les systèmes à photoconducteur travaillant en régime avalanche présentent néanmoins un certain nombre d'inconvénients, parmi lesquels une gigue temporelle importante (de l'ordre de plusieurs dizaines de picosecondes) pour synchroniser des impulsions courtes - nanosecondes ou subnanosecondes. Cette gigue temporelle associé a la commutation optoélectronique, limite les possibilités de contrôler parfaitement le profil temporel et donc spectral du signal électrique engendré. Il en découle une mauvaise reproductibilité des impulsions courtes photogénérées.

Un générateur en régime linéaire est décrit dans la publication WO 2007/074229. Ce générateur comprend un moyen de stockage de charges électriques, une source haute tension apte à alimenter en charge ledit moyen de stockage des charges. Il comprend également deux éléments photoconducteurs passifs en silicium dopé et fonctionnant en régime linéaire formant des commutateurs photosensibles, le premier étant relié, d'une part, à la référence des potentiels et, d'autre part, audit moyen de stockage, le deuxième étant relié, d'une part, au moyen de stockage et, d'autre part, à une charge utile. Il comprend enfin une première source lumineuse apte à délivrer une impulsion lumineuse audit premier photoconducteur, une seconde source lumineuse apte à délivrer une impulsion lumineuse audit second photoconducteur, ainsi qu'un moyen de synchronisation du retard d'émission entre la première et la deuxième source lumineuse.

Un tel générateur permet de fournir des impulsions électriques d'amplitude crête-à-crête de plusieurs kilovolts pour une durée du signal bipolaire subnanoseconde. De plus, la gigue temporelle est rendue très faible - de l'ordre de la picoseconde -, ce qui permet de contrôler finement le profil du spectre du signal délivré. Enfin, ce générateur permet une grande reproductibilité de la source et présente une durée de vie très élevée.

Cependant, un générateur optoélectronique en régime linéaire présente plusieurs inconvénients. En particulier, le contrôle du contenu spectral de l'impulsion par réglage du retard temporel entre les deux commutateurs photosensibles ne permet pas une maîtrise suffisante de ce contenu. De plus, les moyens de réglage du retard temporel entre les deux photocommutateurs intègre une ligne à retard, ce qui rend le système encombrant. Un tel générateur ne peut être synchronisé avec d'autres systèmes électriques ou optiques. Enfin, le régime linéaire nécessite une énergie optique importante et donc l'utilisation de sources lasers encombrantes.

Ainsi, aucune solution de l'état de la technique ne permet de disposer d'un générateur d'impulsions électriques qui soit peu encombrant et apte à être synchronisé à d'autres systèmes électriques ou optiques, avec des impulsions générées de forte puissance (quelques kilovolts), de courte durée (nanoseconde et en dessous) et à contenu spectral contrôlable.

### OBJET DE L'INVENTION

Le but de la présente invention est de remédier à ces problèmes techniques, en permettant aux générateurs d'impulsions électriques haute tension à ondes gelées - qui peuvent fournir des impulsions de forte puissance et de courte durée - de contrôler le contenu spectral des impulsions, tout en le rendant apte à être synchronisé avec d'autres systèmes électriques ou optiques.

L'approche de la solution a consisté à trouver, sur les générateurs d'impulsions électriques haute tension à ondes gelées de l'état de l'art, un autre moyen pour contrôler le contenu spectral de l'impulsion que l'introduction d'un retard temporel. Cela a conduit à réaliser le contrôle de ce contenu spectral par le réglage de la différence de puissance nécessaire à l'illumination de chacun des deux composants semiconducteurs. Cette différence peut en particulier être réglable avec une source lumineuse générant un faisceau, des moyens de fractionnement dudit faisceau en deux fractions de faisceau ainsi que des moyens de contrôle de la répartition des puissances respectives desdites deux fractions dudit faisceau. Cette modification de la puissance incidente permet en outre une meilleure compacité du générateur.

Dans ce but, l'invention a pour objet un générateur d'impulsions électriques haute tension du type mentionné ci-dessus dans lequel, outre les caractéristiques déjà mentionnées, le système de déclenchement comprend des moyens de génération d'un faisceau laser lumineux et des moyens de fractionnement dudit faisceau laser en deux fractions de faisceau laser, chaque fraction de faisceau laser étant respectivement dirigée vers un élément photoconducteur du système de génération, lesdits moyens de fractionnement étant aptes à contrôler la répartition des puissances respectives desdites deux fractions de faisceau laser en fonction de l'orientation de la polarisation du faisceau laser.

Un tel générateur, formé de la combinaison des systèmes de génération et de déclenchement, permet de résoudre les problèmes techniques ci-dessus, puisque le profil des impulsions générées peut être contrôlé par l'orientation de la polarisation du faisceau, ce qui peut être fait avec une très grande précision. Cela permet, d'une part, de bénéficier d'une très faible gigue temporelle du fait du système de génération d'impulsions haute tension à ondes gelées et, d'autre part, de pouvoir contrôler le contenu spectral des impulsions, leur profil spectral étant ajustable. De plus, le faisceau laser permettant le déclenchement des impulsions peut être dirigé vers d'autres systèmes ou générateurs de sorte à y jouer le rôle de référence pour la synchronisation de tous les systèmes.

Dans un mode de réalisation particulier, il est prévu que les moyens de fractionnement comprennent un moyen de retard de phase à polarisation rectiligne et un moyen de polarisation rectiligne par séparation de faisceau agencé de sorte à séparer ledit faisceau laser en deux fractions de faisceau laser, chaque fraction de faisceau laser étant respectivement dirigée vers un élément photoconducteur du système de génération, la répartition des puissances respectives desdites deux fractions de faisceau laser étant contrôlée par orientation dudit moyen de retard de phase à polarisation rectiligne.

Dans ce cas, c'est l'orientation du moyen de retard de phase à polarisation rectiligne qui permettra de modifier l'orientation de la polarisation rectiligne du faisceau laser issu de la source laser. Le moyen de polarisation rectiligne par séparation de faisceau réalisera alors le fractionnement du faisceau laser en deux fractions dirigées vers les deux photocommutateurs. Les puissances respectives de ces deux fractions seront dès lors fonctions de l'orientation de la polarisation du faisceau laser en sortie du moyen de retard de phase à polarisation rectiligne. Le profil de l'impulsion sera, quant à lui, fonction desdites puissances respectives, ce qui permettra ainsi de contrôler ledit profil via l'orientation de la polarisation dudit faisceau laser.

Dans un mode de réalisation préférentiel, il est prévu que le moyen de retard de phase à polarisation rectiligne soit une lame demi-onde dont l'axe optique est perpendiculaire à l'axe de visée du faisceau laser.

Dans un mode de réalisation préférentiel, il est prévu que le moyen de polarisation rectiligne par séparation de faisceau soit un polariseur de type Wollaston.

Avantageusement, il est prévu que le système de déclenchement des impulsions comprenne également un moyen de focalisation disposé avant le moyen de polarisation rectiligne par séparation de faisceau, de sorte à focaliser chaque fraction de faisceau laser respectivement sur un élément photoconducteur du système de génération. L'efficacité de commutation est ainsi améliorée.

Avantageusement, il est prévu que les moyens de génération du faisceau laser soient de type microlaser. La puissance fournie par ce type de source est en effet suffisante, d'une part, pour réaliser le déclenchement des impulsions avec une grande précision et, d'autre part, pour diriger une proportion suffisante du faisceau laser vers d'autres systèmes optiques et/ou électriques. Un tel générateur bénéficie ainsi d'un encombrement moindre.

La présente invention concerne également une installation de multiples générateurs d'impulsions haute tension comprenant N générateurs d'impulsions haute tension, N étant supérieur ou égal à deux, chaque générateur comprenant un système de génération d'impulsions haute tension à ondes gelées et un système de déclenchement desdites impulsions, ledit système de génération comprenant un premier et un second éléments photoconducteurs, caractérisé en ce que :
- ledit système de déclenchement de chaque générateur comprend des moyens de fractionnement d'un faisceau laser en deux fractions de faisceau laser, chaque fraction de faisceau laser étant respectivement dirigée vers un élément photoconducteur du système de génération, lesdits moyens de fractionnement étant aptes à contrôler la répartition des puissances respectives desdites deux fractions de faisceau laser en fonction de l'orientation de la polarisation du faisceau laser,
- ledit système de déclenchement de l'un parmi lesdits N générateurs comprend des moyens de génération dudit faisceau laser,

- ledit système de déclenchement d'au moins N-1 générateurs comprend un moyen de retard agencé de manière à synchroniser lesdits générateurs entre eux, et
- chaque générateur comprend un moyen de séparation agencé de manière à diriger une partie dudit faisceau laser émis par lesdits moyens de génération vers lesdits moyens de fractionnement dudit générateur.

Une telle installation permet d'obtenir une pluralité de générateurs d'impulsions synchrones entre eux. Il permet notamment de générer des impulsions électriques haute tension de forte puissance et de courte durée, ces impulsions étant synchrones et pouvant être dirigées vers des cibles différentes ou couplées entre elles pour réaliser la somme cohérente de leur puissance.

La présente invention concerne enfin un équipement pompe-sonde électro-optique comprenant un générateur d'impulsions haute tension et un système de sonde, ledit générateur comprenant un système de génération d'impulsions haute tension à ondes gelées et un système de déclenchement desdites impulsions, ledit système de génération comprenant un premier et un second éléments photoconducteurs, caractérisé en ce que :
- ledit système de déclenchement comprend des moyens de génération d'un faisceau laser lumineux et des moyens de fractionnement dudit faisceau laser en au moins deux fractions de faisceau laser, chaque fraction de faisceau laser étant respectivement dirigée vers un élément photoconducteur du système de génération, lesdits moyens de fractionnement étant aptes à contrôler la répartition des puissances respectives desdites au moins deux fractions de faisceau laser en fonction de l'orientation de la polarisation du faisceau laser,
- ledit générateur comprend un moyen de séparation agencé de manière à diriger une partie dudit faisceau laser vers ledit système de génération et une autre partie vers ledit système de sonde, et
- l'équipement comporte au moins un moyen de retard, un moyen de retard étant disposé sur le trajet de l'un parmi lesdites parties dudit faisceau laser de manière synchroniser ledit générateur et ledit système de sonde entre eux.

Un tel équipement présente l'avantage de dédier une partie du faisceau laser de déclenchement à un système de sonde, qui peut servir en outre pour des applications de diagnostic ou d'imagerie. Le générateur - qui joue le rôle de système de pompe - et le système de sonde sont alors synchrones. De plus, l'absence de gigue temporelle entre l'impulsion optique et l'onde électrique photocommutée permet d'analyser en temps réel l'impact de celle-ci sur des éléments biologiques. Enfin, la gestion de l'énergie optique de commutation permet de modifier le spectre de l'impulsion électrique en fonction de la cible à analyser.

Dans un mode de réalisation visant à réaliser à la fois le test et l'excitation de la cible, il est prévu que les faisceaux lumineux issus du générateur et du système de sonde soient dirigés vers une même cible. Il est ainsi possible d'exciter la cible avec le générateur et, en même temps, de tester cette même cible avec le même faisceau laser mais dont le spectre aurait été élargi.

Dans un mode de réalisation visant à changer la longueur d'onde d'excitation en générant un continuum, il est prévu que le système sonde comporte des moyens de conversion non-linéaire large bande. Le continuum ainsi généré par le moyen de conversion est synchrone avec le générateur et permet de tester la cible avec des longueurs d'onde différentes de celles du faisceau laser initial.

Dans un mode de réalisation visant à visualiser le résultat du test de la cible, il est prévu que le système sonde comporte des moyens d'imagerie.

Dans un mode de réalisation visant à reconnaître des composés donnés sur la cible, il est prévu que les moyens d'imagerie soient de type non-linéaire CARS (analyse spectroscopique de la diffusion cohérente anti-Stokes liée à un effet de type Raman, ou « Coherent Anti-Stokes Raman Spectroscopy » en langue anglo-saxonne). Il est ainsi possible de découper et de coder le continuum généré par le moyen de conversion non linéaire et d'appliquer le continuum ainsi traité sur une cible. Ce type de moyen d'imagerie permet de générer des signatures complexes - et donc précises - d'un composé donné par l'obtention d'un spectre de réponse à un spectre d'excitation émis en direction du composé. Cela rend ainsi possible la reconnaissance d'un composé donné par son spectre de réponse à un spectre d'excitation déterminé.

Dans un autre mode de réalisation, il est prévu que les moyens d'imagerie soient de type non linéaire par génération de second harmonique.

Dans un autre mode de réalisation, il est prévu que les moyens d'imagerie soient de type non linéaire par fluorescence.

### BREVE DESCRIPTION DES DESSINS

L'invention sera mieux comprise à la lecture de la description détaillée d'un exemple non limitatif de réalisation, accompagnée de figures représentant respectivement :
- la figure 1, un schéma de générateur d'impulsions électriques haute tension selon l'invention,
- la figure 2A, le signal délivré par le générateur d'impulsions électriques haute tension selon l'invention en l'absence d'excitation lumineuse,
- la figure 2B, le signal délivré par le générateur d'impulsions électriques haute tension lorsqu'un seul semiconducteur reçoit une excitation lumineuse,
- la figure 2C, le signal délivré par le générateur d'impulsions électriques haute tension lorsque les deux semiconducteurs reçoivent une excitation lumineuse,
- la figure 3, un schéma d'installation mettant en oeuvre une pluralité de générateurs d'impulsions électriques haute tension synchrones selon l'invention, et
- la figure 4, un schéma d'équipement pompe-sonde électro-optique mettant en oeuvre un générateur d'impulsions électriques haute tension selon l'invention.

### EXPOSE DETAILLE DE MODES DE REALISATION PARTICULIERS

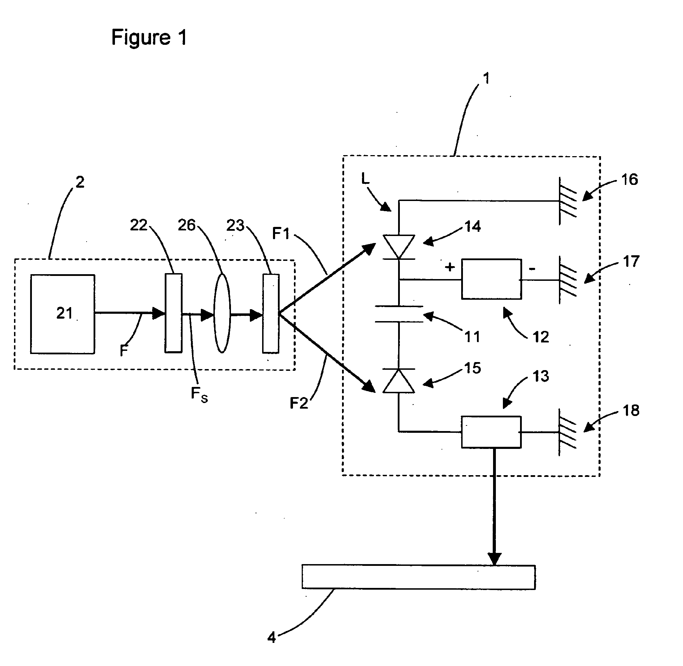

La figure 1 représente le schéma d'un générateur d'impulsions électriques haute tension selon l'invention.

Le générateur comprend un système de génération d'impulsions haute tension à ondes gelées 1 et un système de déclenchement desdites impulsions 2. Les impulsions électriques générées permettent d'exciter une cible 4. Le générateur fonctionne sur le principe d'un dispositif de type « générateur à ondes gelées ».

Le système de génération d'impulsions haute tension à ondes gelées 1 comprend un moyen de stockage de charges 11, une source haute tension 12, une charge utile 13, ainsi que deux éléments semiconducteurs 14 et 15. Tous ces éléments sont disposés sur une ligne de transmission L.

Le moyen de stockage de charges 11 est une ligne de transmission de type coaxiale, microruban, microstrip ou tout type de ligne hyperfréquence. La source haute tension 12 est un moyen de génération continue haute tension apte à alimenter en charge le moyen de stockage de charge 11 auquel elle est connectée à travers une résistance de charge inclue ou non dans cette même source. Elle peut fonctionner en régime continu ou impulsionnel. La charge utile 13 permet l'émission de l'impulsion électrique.

Le premier élément semiconducteur 14 est relié d'une part à la référence 16 des potentiels et d'autre part audit moyen de stockage 11. Le second élément photoconducteur 15 est relié d'une part audit moyen de stockage 11 et d'autre part à ladite charge utile 13. Les deux éléments semiconducteurs 14 et 15 sont susceptibles d'être excités par deux faisceaux lumineux respectifs provenant du système de déclenchement des impulsions 2. Ils sont réversibles dans le cas ou l'on inverse la polarité de la source haute tension 12 et jouent le rôle de photocommutateurs.

De façon à obtenir le comportement d'un commutateur ouvert en l'absence d'excitation lumineuse, les semiconducteurs 14 et 15 sont dopés. Le dopage est constitué par un excès de charges positives et négatives périodique de type n-p. Une période unique de dopage constitue alors une jonction de type diode. Cette diode est montée en inverse par rapport à la polarisation du moyen de stockage de charges 11 et se comporte donc comme un commutateur ouvert en l'absence d'excitation lumineuse. Les deux semiconducteurs peuvent ainsi être composés de silicium dopé N et P.

Lorsque les semiconducteurs 14 et 15 ne sont pas éclairés, ils présentent une résistance propre importante de plusieurs dizaines de Mégaohms et peuvent alors être considérées comme des commutateurs ouverts.

Après illumination par une impulsion optique brève, la résistance des composants éclairés est sensiblement diminuées et est proche de quelques dizaines de ohms, typiquement 5 à 30 ohms. Le commutateur est alors fermé et cette fermeture est d'autant plus efficace que l'énergie optique est absorbée. Cette réduction de la résistance interne du composant permet la libération instantanée de l'énergie contenue dans le moyen de stockage de charges 11, à la vitesse de réactivité près de ce dernier. L'onde stationnaire contenue dans le moyen de stockage de charges 11 est alors libérée. Les fronts de cette onde stationnaire se propagent alors dans les deux directions opposées.

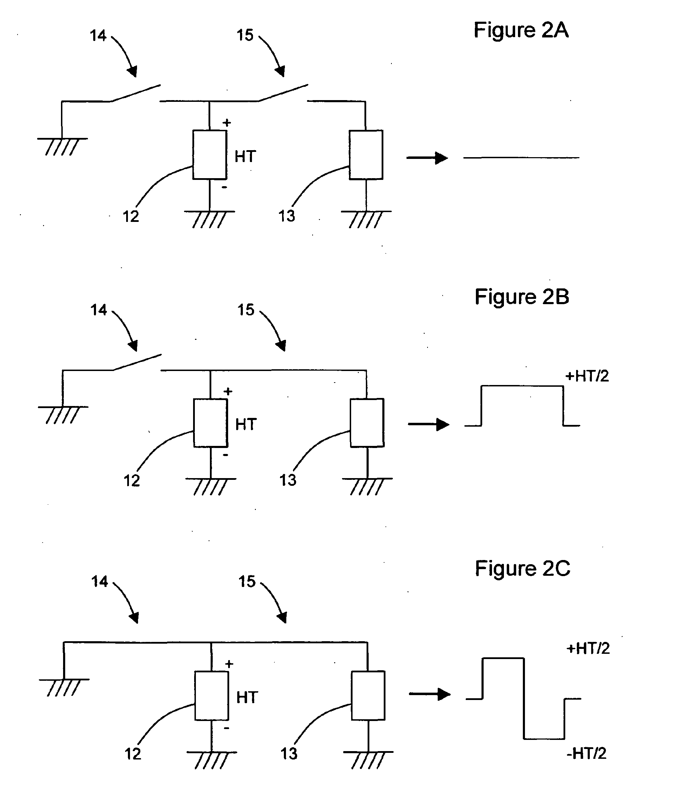

Ainsi, en référence à la figure 2A, lorsque les semiconducteurs 14 et 15 ne sont pas éclairés, ils peuvent être considérés comme des commutateurs ouverts.

En référence à la figure 2B, lorsque seul le semiconducteur 15 est éclairé, le front d'onde se propageant directement vers la charge utile 13 à une tension de même signe que celle de la tension de polarisation appliquée au moyen de stockage de charges 11. Un impulsion électrique est alors obtenue.

En référence à la figure 2C, lorsque les deux semiconducteurs 14 et 15 sont éclairés, le front d'onde se propageant directement vers la charge utile 13 à une tension de même signe que celle de la tension de polarisation appliquée au moyen de stockage de charges 11. La partie de cette onde se propageant vers la référence des potentiels 16 va se réfléchir avec une inversion de sa polarisation. Une impulsion de signe opposé à celui de la tension de polarisation est alors engendrée et suit directement la première impulsion de même signe que celui de la tension de polarisation. L'association des deux signaux forme alors un signal bipolaire.

Ainsi, dans le cas où les semiconducteurs sont éclairés en même temps et avec la même puissance, le générateur selon l'invention permet d'obtenir un monocycle équilibré, c'est-à-dire de valeur moyenne quasiment nulle.

De façon à ce que le générateur fonctionne en régime linéaire, les deux semiconducteurs 14 et 15 sont agencés pour fonctionner dans un régime linéaire. La réduction de l'impédance des semiconducteurs - et donc l'énergie commutée - dépend alors linéairement de l'énergie optique absorbée par les semiconducteurs.

De façon à adapter au mieux l'impédance locale du composant à celle de la ligne de transmission et à celle du connecteur de sortie, les semiconducteurs 14 et 15 sont isolés de façon importante par rapport au potentiel par le biais d'un diélectrique isolant comme de l'air, du silicone, de la colle, ou du téflon.

Comme illustré à nouveau en figure 1, le système de déclenchement des impulsions 2 permet de contrôler le contenu spectral de l'impulsion électrique générée par le système de génération 1. Ce système 2 contrôle les puissances lumineuses respectives reçues par chacun des deux semiconducteurs 14 et 15, et plus particulièrement la différence entre ces deux puissances lumineuses. Le contrôle de cette différence permet alors de modifier le profil de l'impulsion électrique en sortie du générateur et donc d'ajuster le contenu spectral de cette impulsion.

Plus précisément, ce système de déclenchement 2 comprend des moyens de génération 21 d'un faisceau laser lumineux F, ainsi que des moyens de fractionnement 22 et 23 dudit faisceau F en deux fraction F1 et F2.

Les moyens de génération 21 d'un faisceau laser F sont constitués d'une source optique linéairement polarisée de type laser 21. Cette source émet un faisceau lumineux laser F polarisé linéairement en direction des moyens de fractionnement 22 et 23.

Les moyens de fractionnement 22 et 23 réalisent le fractionnement du faisceau lumineux laser F en deux fractions de faisceau F1 et F2, chaque fraction de faisceau étant respectivement dirigée vers l'un des deux éléments semiconducteurs 14 et 15 du système de génération 1. Ces moyens de fractionnement 22 et 23 réalisent également le contrôle de ce fractionnement, et plus particulièrement le contrôle de la différence entre les puissances lumineuses respectives des deux fractions de faisceau F1 et F2.

Dans l'exemple de réalisation illustré, ces moyens de fractionnement comprennent à cet effet un moyen de retard de phase à polarisation rectiligne 22 et un moyen de polarisation rectiligne par séparation de faisceau 23.

Le moyen de retard de phase à polarisation rectiligne 22 est ici une lame demi-onde. Il est réalisé par un milieu biréfringent pouvant modifier l'orientation de la direction de polarisation linéaire du faisceau F issu de la source 21.

Le faisceau traverse ensuite un moyen de polarisation rectiligne par séparation de faisceau 23, ou polariseur, permettant de transformer un faisceau incident en deux faisceaux ayant des polarisations rectilignes perpendiculaires. Celui-ci sépare ainsi le faisceau F en deux fractions de faisceau, F1 et F2, présentant des polarisations linéaires perpendiculaires. Chaque fraction de faisceau F1,F2 est ensuite dirigée respectivement vers l'un des deux semiconducteurs 14,15.

L'orientation du polariseur 23 est fixe. La gestion de la différence de puissance entre les deux fractions de faisceau F1,F2 est fournie par l'orientation de la lame 22. Par conséquent, il est possible d'obtenir n'importe quelle orientation de la polarisation rectiligne du faisceau F. Le polariseur 23 réalisera alors le fractionnement du faisceau F_{S} en deux fractions de faisceaux F1 et F2 de polarisations orientés suivant les axes privilégiés du polariseur. La différence de puissance entre les deux fractions de faisceau ainsi formées dépend donc de l'orientation de la polarisation du faisceau F_{S} en sortie de la lame, elle-même dépendante de l'orientation de la lame.

Ce type de polariseur par séparation de faisceau présente l'avantage d'absorber très peu de lumière, par rapport aux polariseurs par absorption. Selon un mode particulier de réalisation, le polariseur 23 est un polariseur de type Wollaston. Ce type de polariseur présente en effet des propriétés de biréfringence qui permettent d'obtenir deux faisceaux F1 et F2 présentant des polarisations rectilignes et perpendiculaires entre elles.

Ce système de déclenchement 2 des impulsions selon l'invention rompt avec l'utilisation des systèmes de déclenchement selon l'état de l'art pour ce type de générateur et qui sont constitués d'un moyen de synchronisation. Ce moyen de synchronisation permet de contrôler le retard des deux fractions de faisceau l'une part rapport à l'autre, en décalant les instants de fermeture des deux photocommutateurs. Cela permet de moduler le signal de sortie, par exemple en fournissant un signal sur lequel la durée d'émission du signal positif est supérieure à la durée d'émission du signal négatif. Le contenu spectral du signal est ainsi modulé. Cependant, un tel moyen de synchronisation ne permet pas de réaliser une modulation suffisamment précise ni de synchroniser le générateur d'impulsions électriques ainsi constitué avec d'autres systèmes électriques ou optiques. Avantageusement, la source laser est un laser compact de type « microlaser » (ou « microchip » en langue anglo-saxonne) fonctionnant en régime déclenché. Ce type de laser produit des impulsions subnanosecondes ou nanosecondes de quelques microjoules à plusieurs millijoules. Le refroidissement de ces lasers est réalisé par échange thermique dans l'air. Ils fonctionnent à des fréquences comprises entre quelques dizaines de hertz et plusieurs dizaines de kilohertz. Les impulsions issues de ces sources permettent donc de commuter des impulsions électriques de plusieurs kilovolts et sont potentiellement amplifiables pour atteindre des énergies encore supérieures.

Le générateur d'impulsions électriques haute tension ainsi formé de la combinaison des systèmes de génération 1 et de déclenchement 2 permet ainsi de contrôler le profil des impulsions générées pour exciter la cible 4, et par conséquent leur contenu spectral. De plus, ce générateur est apte à être synchronisé avec d'autres systèmes électriques et/ou optiques, ou d'autres générateurs selon la présente invention. En effet, le faisceau laser F permettant le déclenchement des impulsions peut être dirigé vers d'autres systèmes ou générateurs de sorte à y jouer le rôle de référence pour la synchronisation de tous les systèmes.

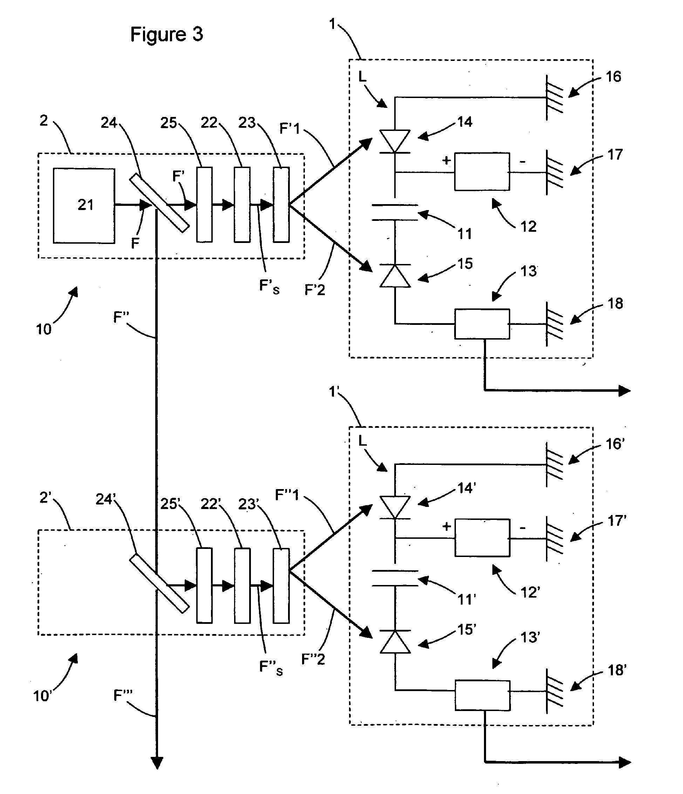

A titre d'exemple, la figure 3 représente le schéma d'une installation mettant en oeuvre une pluralité de générateurs d'impulsions électriques haute tension synchrones décrits ci-dessus, limité à deux dans l'exemple illustré.

Cette installation comprend un premier générateur d'impulsion (10) tel que décrit précédemment en référence à la figure 1. Le deuxième générateur d'impulsion (10') est analogue au premier générateur (10), mais il ne comprend pas de source laser. En effet, cette source 21 est commune aux deux générateurs. Ainsi, seul le premier générateur en comporte une.

La lame séparatrice 24 permet de prélever une partie F" du faisceau laser F issu de la source laser 21, cette partie prélevée étant dirigée, par réflexion sur une lame séparatrice 24', vers le moyen de fractionnement (22',23') du deuxième générateur, tandis que la partie non prélevée est dirigée vers le moyen de fractionnement (22,23) du premier générateur.

Le système de déclenchement 2 comprend un moyen de retard 25 disposé sur le trajet du faisceau F' permettant de contrôler la synchronisation entre les générateurs 1 et 1' en modifiant la longueur du trajet du faisceau F'. Ce moyen de retard peut être une ligne à retard composée de plusieurs miroirs ou de fibres optiques dont on modifie la longueur par application d'une contrainte mécanique. Un moyen de retard 25' peut également être disposé de la même manière dans le système de déclenchement 2'.

Selon d'autres modes de réalisation, l'installation comporte une pluralité de générateurs d'impulsions selon l'invention, par exemple à partir d'une partie F"' du faisceau F" transmis par la lame 24', de sorte qu'un seul d'entre eux comporte une source laser apte à permettre la synchronisation avec les autres générateurs par l'intermédiaire de lames séparatrices et de lignes à retard. L'installation peut ainsi comporter N générateurs d'impulsions haute tension, N étant supérieur ou égal à deux. Chaque générateur comprenant un système de génération d'impulsions haute tension à ondes gelées 1,1' et un système de déclenchement desdites impulsions 2,2', ledit système de génération 1,1' comprenant un premier 14,14' et un second 15,15' éléments photoconducteurs.

Le système de déclenchement 2,2' de chaque générateur comprend des moyens de fractionnement 22,22',23,23' d'un faisceau laser F',F" en deux fractions de faisceau laser F'1,F"1,F'2,F"2, chaque fraction de faisceau laser étant respectivement dirigée vers un élément photoconducteur 14,14',15,15' du système de génération 1,1', lesdits moyens de fractionnement étant aptes à contrôler la répartition des puissances respectives desdites deux fractions de faisceau laser en fonction de l'orientation de la polarisation du faisceau laser. Le système de déclenchement 2 de l'un parmi lesdits N générateurs comprend des moyens de génération 21 dudit faisceau laser F. Le système de déclenchement 2 d'au moins N-1 générateurs comprend au moins un moyen de retard 25,25' agencé de manière à synchroniser lesdits générateurs entre eux. Chaque générateur comprend un moyen de séparation 24,24' agencé de manière à diriger une partie dudit faisceau laser F émis par lesdits moyens de génération 21 vers lesdits moyens de fractionnement dudit générateur.

Cette installation permet d'obtenir une pluralité de générateurs d'impulsions selon l'invention, tous les générateurs étant synchrones entre eux. Il permet notamment de générer des impulsions électriques haute tension de forte puissance et de courte durée, ces impulsions étant synchrones et pouvant être dirigées vers plusieurs cibles ou plusieurs zones d'une même cible. La désynchronisation de plusieurs générateurs peut également être réalisée en réglant les lignes à retard.

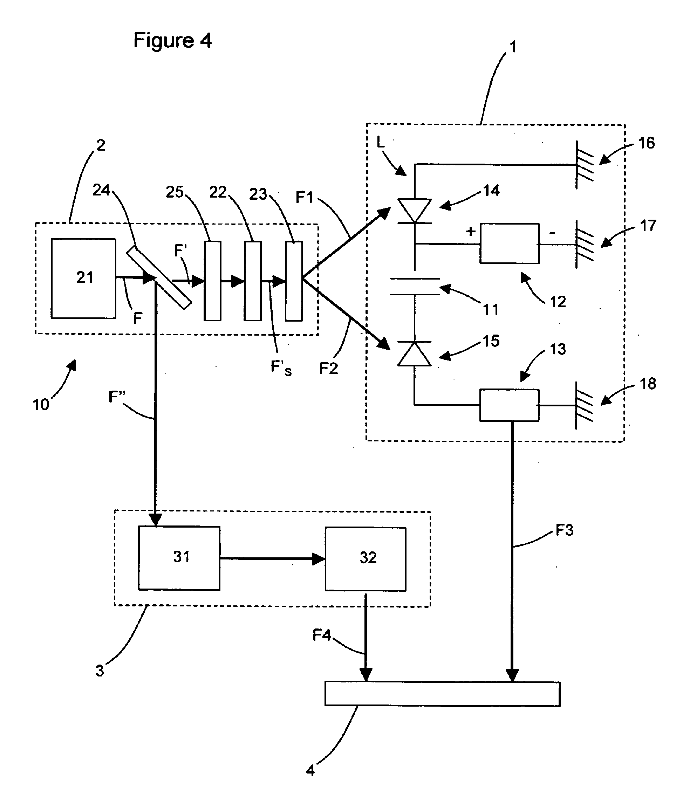

La figure 4 représente le schéma d'un équipement pompe-sonde électro-optique mettant en oeuvre un générateur d'impulsions électriques haute tension décrit ci-dessus.

Plus précisément, cet équipement pompe-sonde comprend un générateur d'impulsions haute tension tel que décrit précédemment en référence à la figure 1. Ce générateur joue le rôle de pompe. Il comprend en particulier un système de génération d'impulsions haute tension à ondes gelées 1 et un système de déclenchement desdites impulsions 2. Le système de génération 1 comprend un premier 14 et un second 15 éléments photoconducteurs. Le système de déclenchement 2 comprend des moyens de génération 21 d'un faisceau laser lumineux F et des moyens de fractionnement 22,23 dudit faisceau laser F en au moins deux fractions de faisceau laser F1,F2. Chaque fraction de faisceau laser est respectivement dirigée vers un élément photoconducteur du système de génération. Les moyens de fractionnement sont aptes à contrôler la répartition des puissances respectives desdites au moins deux fractions de faisceau laser en fonction de l'orientation de la polarisation du faisceau laser F.

Cet équipement pompe-sonde comprend également un moyen de séparation 24 agencé de manière à diriger une partie F' dudit faisceau laser F vers le système de génération 1 et une autre partie F" vers ledit système de sonde 3. Ce moyen de séparation 24 est une lame séparatrice 24 placée entre la sortie de la source laser 21 et la lame demi-onde 22 associée au polariseur 23. A partir du faisceau F généré par la source laser 21, cette lame 24 permet d'émettre un faisceau laser F' en direction du système de fractionnement 22,23 et un faisceau laser F" pouvant servir à la synchronisation du générateur avec les autres systèmes, en particulier d'autres générateurs ou, comme décrit ci-dessus, un système d'imagerie. Ce faisceau F" est suffisamment énergétique - 10 kilowatts crête - pour réaliser une conversion de fréquence, par exemple dans un cristal ou une fibre non linéaire.

Cet équipement pompe-sonde comprend également un système de sonde 3, lequel comprend un moyen de conversion non-linéaire large bande 31 et un moyen d'imagerie non-linéaire 32. Le faisceau F" issu de la lame séparatrice 24 est dirigé vers le moyen de conversion non-linéaire large bande 31, qui permet de changer la longueur d'onde d'excitation en générant un continuum. Le continuum ainsi généré par le moyen de conversion 31 est synchronisé avec le générateur au moyen d'une ligne à retard 25 placée sur le trajet du faisceau F'. Le moyen de conversion 31 peut être par exemple un cristal non-linéaire ou une fibre non-linéaire de type microstructurée.

Cet équipement pompe-sonde comprend enfin un moyen de retard 25 permettant de synchroniser le générateur et le système de sonde 3 entre eux. Ce moyen de retard 25 peut être une ligne de retard disposée entre la lame séparatrice 24 et la lame 22. Il est ainsi disposé sur le trajet de la partie F' du faisceau laser F de manière à synchroniser cette partie F' avec l'autre partie F" du faisceau F. Selon un autre mode de réalisation, le moyen de retard 25 peut être disposé sur le trajet de l'autre partie F" du faisceau F de sorte à synchroniser cette partie F" avec la partie F' du faisceau. Le moyen d'imagerie non-linéaire 32 permet de découper et de coder le continuum généré par le moyen de conversion 32, et d'appliquer le continuum ainsi traité sur la cible 4. Ce type de moyen d'imagerie, de par son caractère non-linéaire, permet de générer des signatures complexes - et donc précises - d'un composé donné par l'obtention d'un spectre de réponse à un spectre d'excitation émis en direction du composé. En effet, un moyen d'imagerie linéaire ne permet pas de différencier suffisamment la signature d'un composé unique parmi un ensemble d'autres composés.

Ce moyen d'imagerie non-linéaire peut être par exemple de type CARS (analyse spectroscopique de la diffusion cohérente anti-Stokes liée à un effet de type Raman, ou « Coherent Anti-Stokes Raman Spectroscopy » en langue anglo-saxonne). Ce type d'imagerie peut fonctionner en régime large bande et utiliser une source lumineuse subnanoseconde présentant un supercontinuum.

Ce type d'imagerie est par exemple décrit dans les publications suivantes :
- Masanari Okuno, Hideaki Kano, Philippe Leproux, Vincent Couderc, Hiro-o Hamaguchi, « Ultrabroadband (>2000 cm-1) Multiplex Coherent Anti-Stokes Raman Scattering Spectroscopy Using a Sub-Nanosecond Supercontinuum Light Source » ; Optics Letters, vol. 32, n° 20, p. 3050-3052, 2007, et
- Masanari Okuno, Hideaki Kano, Philippe Leproux, Vincent Couderc, Hiro-o Hamaguchi, « Ultrabroadband multiplex CARS microspectroscopy and imaging using a subnanosecond supercontinuum light source in the deep near infra-red », à paraitre dans Optics Letters 2008.

Selon d'autres modes particuliers de réalisation, le moyen d'imagerie peut être l'un parmi une imagerie SHG (génération de seconde harmonique, ou « Second Harmonic Generation » en langue anglo-saxonne), par fluorescence ou par diffraction.

Un tel équipement pompe-sonde électro-optique présente le double avantage de bénéficier d'une génération d'impulsions électriques haute tension de forte puissance, à profil ajustable et de courte durée, tout en étant synchrone avec une sonde pour tester la cible 4. Ces effets supplémentaires sont rendus possibles par l'utilisation de la source laser 21 à la fois comme moyen de déclenchement des impulsions générées par le système de génération 1, et comme moyen de synchronisation avec un système d'imagerie permettant le test de la cible.

Selon un mode particulier de réalisation, l'équipement pompe-sonde comprend plusieurs générateurs d'impulsions électriques haute tension décrits ci-dessus, ces générateurs étant reliés les uns aux autres et synchronisés.

Un équipement selon la présente invention trouve des applications notamment, et de manière non limitative, dans le domaine médical. En effet, les systèmes actuels d'électrostimulation cellulaire utilisent des générateurs électroniques produisant des impulsions longues de type microseconde ou milliseconde. Or certaines cellules sont susceptibles de répondre à des excitations bien plus brèves et jusqu'à une échelle de temps de l'ordre de la nanoseconde, de la picoseconde ou de la femtoseconde.

Les systèmes de l'état de l'art ne permettent pas d'analyser en temps réel l'influence de ces impulsions électromagnétiques très courtes du fait de la non synchronisation des systèmes d'excitation et/ou d'imagerie. La présente invention permet de résoudre ce problème, puisque l'impulsion électrique y est directement engendrée par l'onde optique dont une partie sera dédiée au système de diagnostic ou d'imagerie. Le générateur est ainsi synchronisé avec d'autres générateurs ou avec d'autres systèmes électriques ou optiques. Dans ces conditions, l'absence de gigue temporelle entre l'impulsion et l'onde électrique photocommutée permet d'analyser en temps réel l'impact de celle-ci sur des éléments biologiques. De plus, la gestion de l'énergie optique de commutation permet de modifier le spectre de l'impulsion électrique et l'utilisation d'un laser de type « microchip » permet de minimiser l'encombrement et de réduire significativement le coût d'un tel système.

Un générateur selon la présente invention trouve également des applications dans le domaine de l'imagerie électronique, par exemple pour des radars, en vue de mettre en parallèle plusieurs systèmes ou de déclencher en même temps plusieurs commutateurs électroniques.

Plus généralement, un générateur selon la présente invention peut trouver des applications lorsque l'on recherche la synchronisation de plusieurs systèmes électriques ou optiques et/ou des générateurs d'impulsions électriques haute tension.

## Revendications

1. - Générateur d'impulsions haute tension comprenant un système de génération d'impulsions haute tension à ondes gelées (1) et un système de déclenchement desdites impulsions (2), ledit système de génération (1) comprenant un premier (14) et un second (15) éléments photoconducteurs, **caractérisé en ce que** ledit système de déclenchement (2) comprend des moyens de génération (21) d'un faisceau laser lumineux (F) et des moyens de fractionnement (22,23) dudit faisceau laser (F) en deux fractions de faisceau laser (F1,F2), chaque fraction de faisceau laser (F1,F2) étant respectivement dirigée vers un élément photoconducteur (14,15) du système de génération (1), lesdits moyens de fractionnement (22,23) étant aptes à contrôler la répartition des puissances respectives desdites deux fractions de faisceau laser (F1,F2) en fonction de l'orientation de la polarisation du faisceau laser (F).

2. - Générateur d'impulsion haute tension selon la revendication 1, dans lequel les moyens de fractionnement (22,23) comprennent un moyen de retard de phase à polarisation rectiligne (22) et un moyen de polarisation rectiligne par séparation de faisceau (23) agencé de sorte à séparer ledit faisceau laser (F) en deux fractions de faisceau laser (F1,F2), chaque fraction de faisceau laser (F1,F2) étant respectivement dirigée vers un élément photoconducteur (14,15) du système de génération (1), la répartition des puissances respectives desdites deux fractions de faisceau laser (F1,F2) étant contrôlée par orientation dudit moyen de retard de phase à polarisation rectiligne (22).

3. - Générateur d'impulsion haute tension selon la revendication 2, dans lequel le moyen de retard de phase à polarisation rectiligne (22) est une lame demi-onde dont l'axe optique est perpendiculaire à l'axe de visée du faisceau laser (F).

4. - Générateur d'impulsion haute tension selon l'une quelconque des revendications 2 ou 3, dans lequel le moyen de polarisation rectiligne par séparation de faisceau (23) est un polariseur de type Wollaston.

5. - Générateur d'impulsion haute tension selon l'une quelconque des revendications précédentes, dans lequel le système de déclenchement des impulsions (2) comprend également un moyen de focalisation (26) disposé avant le moyen de polarisation rectiligne par séparation de faisceau (23), de sorte à focaliser chaque fraction de faisceau laser (F1,F2) respectivement sur un élément photoconducteur (14,15) du système de génération (1).

6. - Générateur d'impulsion haute tension selon l'une quelconque des revendications précédentes, dans lequel les moyens de génération (21) du faisceau laser (F) sont de type microlaser.

7. - Installation de multiples générateurs d'impulsions haute tension comprenant N générateurs d'impulsions haute tension, N étant supérieur ou égal à deux, chaque générateur comprenant un système de génération d'impulsions haute tension à ondes gelées (1,1') et un système de déclenchement desdites impulsions (2,2'), ledit système de génération (1,1') comprenant un premier (14,14') et un second (15,15') éléments photoconducteurs, **caractérisé en ce que** :
- ledit système de déclenchement (2,2') de chaque générateur comprend des moyens de fractionnement (22,22',23,23') d'un faisceau laser (F',F") en deux fractions de faisceau laser (F'1,F"1,F'2,F"2), chaque fraction de faisceau laser (F1',F"1,F'2,F"2) étant respectivement dirigée vers un élément photoconducteur (14,14',15,15') du système de génération (1,1'), lesdits moyens de fractionnement (22,22',23,23') étant aptes à contrôler la répartition des puissances respectives desdites deux fractions de faisceau laser (F'1,F"1,F'2,F"2) en fonction de l'orientation de la polarisation du faisceau laser (F,F'),
- ledit système de déclenchement (2) de l'un parmi lesdits N générateurs comprend des moyens de génération (21) dudit faisceau laser (F),
- ledit système de déclenchement (2) d'au moins N-1 générateurs comprend au moins un moyen de retard agencé de manière à synchroniser lesdits générateurs entre eux, et
- chaque générateur comprend un moyen de séparation (24,24') agencé de manière à diriger une partie dudit faisceau laser (F) émis par lesdits moyens de génération (21) vers lesdits moyens de fractionnement (22,22',23,23') dudit générateur.

8. - Equipement pompe-sonde électro-optique comprenant un générateur d'impulsions haute tension et un système de sonde (3), ledit générateur comprenant un système de génération d'impulsions haute tension à ondes gelées (1) et un système de déclenchement desdites impulsions (2), ledit système de génération (1) comprenant un premier (14) et un second (15) éléments photoconducteurs, **caractérisé en ce que** :
- ledit système de déclenchement (2) comprend des moyens de génération (21) d'un faisceau laser lumineux (F) et des moyens de fractionnement (22,23) dudit faisceau laser (F) en au moins deux fractions de faisceau laser (F1,F2), chaque fraction de faisceau laser (F1,F2) étant respectivement dirigée vers un élément photoconducteur (14,15) du système de génération (1), lesdits moyens de fractionnement (22,23) étant aptes à contrôler la répartition des puissances respectives desdites au moins deux fractions de faisceau laser (F1,F2) en fonction de l'orientation de la polarisation du faisceau laser (F),
- ledit générateur comprend un moyen de séparation (24) agencé de manière à diriger une partie (F') dudit faisceau laser (F) vers ledit système de génération (1) et une autre partie (F") vers ledit système de sonde (3), et
- l'équipement comporte au moins un moyen de retard (25), un moyen de retard (25) étant disposé sur le trajet de l'un parmi lesdites parties (F'F") dudit faisceau laser (F) de manière synchroniser ledit générateur et ledit système de sonde (3) entre eux.

9. - Equipement pompe-sonde électro-optique selon la revendication 8, dans lequel les faisceaux lumineux (F3,F4) issus du générateur (10) et du système de sonde (3) sont dirigés vers une même cible (4).

10. - Equipement pompe-sonde électro-optique selon l'une quelconque des revendications 8 ou 9, dans lequel le système sonde (3) comporte des moyens de conversion non-linéaire large bande (31).

11. - Equipement pompe-sonde électro-optique selon l'une quelconque des revendications 8 à 10, dans lequel le système sonde (3) comporte des moyens d'imagerie (32).

12. - Equipement pompe-sonde électro-optique selon la revendication 11, dans lequel lesdits moyens d'imagerie (32) sont de type non-linéaire CARS.

13. - Equipement pompe-sonde électro-optique selon la revendication 11, dans lequel lesdits moyens d'imagerie (32) sont de type non linéaire par génération de second harmonique.

14. - Equipement pompe-sonde électro-optique selon la revendication 11, dans lequel lesdits moyens d'imagerie (32) sont de type non linéaire par fluorescence.

## Claims

1. A high-voltage pulse generator comprising a frozen-wave high-voltage pulse generation system (1) and a system (2) for triggering said pulses, said generation system (1) comprising first (14) and second (15) photoconductor elements, **characterized in that** said triggering system (2) comprises means (21) for generating a laser light beam (F) and means (22, 23) for splitting said laser beam (F) into two laser beam fractions (F1, F2), each laser beam fraction (F1, F2) being respectively directed onto a photoconductor element (14, 15) of the generation system (1), said splitting means (22, 23) being capable of controlling the distribution of the respective powers of said two laser beam fractions (F1, F2) as a function of the orientation of the laser beam (F) polarization.

2. The high-voltage pulse generator according to claim 1, wherein the splitting means (22, 23) comprise a rectilinear polarization phase delay means (22) and a beam separation-based rectilinear polarization means (23) arranged so as to divide said laser beam (F) into two laser beam fractions (F1, F2) each fraction of the laser beam (F1, F2) being respectively directed towards a photoconductor element (14, 15) of the generation system (1), the distribution of the respective powers of said two laser beam fractions (F1 F2) being controlled by orienting said rectilinear polarization phase delay means (22).

3. The high-voltage pulse generator according to claim 2, wherein the rectilinear polarization phase delay means (22) is a half-wave plate the optical axis of which is perpendicular to the sight axis of the laser beam (F).

4. The high-voltage pulse generator according to any one of claims 2 or 3, wherein the beam separation-based rectilinear polarization means (23) is a Wollaston type polarizer.

5. The high-voltage pulse generator according to any one of the preceding claims, wherein the pulse triggering system (2) also includes a focalization means (26) arranged before the beam separation-based rectilinear polarization means (23), such as to respectively focalize each laser beam fraction (F1, F2) on a photoconductor element (14, 15) of the generation system (1).

6. The high-voltage pulse generator according to any one of the preceding claims, wherein the means (21) for generating the laser beam (F) are micro-laser type generation means.

7. A multiple high-voltage pulse generators facility comprising N high-voltage pulse generators, N being higher than or equal to two, each generator comprising a frozen-wave high-voltage pulse generator system (1, 1') and a system (2, 2') for triggering said pulses, said generation system (1, 1') comprising first (14, 14') and second (15, 15') photoconductor elements, **characterized in that**:
- said triggering system (2, 2') of each generator comprises means (22, 22', 23, 23') for splitting a laser beam (F', F") into two laser beam fractions (F'1, F"1, F'2, F"2), each laser beam fraction (F'1, F"1, F'2, F"2) being respectively directed onto a photoconductor member (14, 14', 15, 15') of the generation system (1,1'), said splitting means (22,22',23,23') being capable of controlling the distribution of the respective powers of said two laser beam fractions (F'1, F"1,F'2, F"2) as a function of the orientation of the laser beam (F,F') polarization,
- said triggering system (2) of one of said N generators comprises means (21) for generating said laser beam (F).
- said triggering system (2) of at least N-1 generators comprises at least a delay means arranged so as to synchronize said generators, with each other and
- each generator comprises a separation means (24, 24') arranged so as to direct one portion of said laser beam (F) emitted by said generation means (21) towards said means (22, 22', 23, 23') for splitting said generator.

8. An optoelectronic pump-probe equipment comprising a high-voltage pulse generator and a probe system (3), said generator comprising a frozen-wave high-voltage pulse generation system (1) and a system (2) for triggering said pulses, said generation system (1) comprising first (14) and second (15) photoconductor elements, **characterized in that**:
- said triggering system (2) comprises means (21) for generating a light laser beam (F) and means (22, 23) for splitting said laser beam (F) into at least two fractions of the laser beam (F1, F2), each laser beam fraction (F1, F2) being respectively directed towards a photoconductor element (14, 15) of the generation system (1), said splitting means (22, 23) being capable of controlling the distribution of the respective powers of said at least two laser beam fractions (F1, F2) according to the orientation of the laser beam (F) of the polarization,
- said generator comprises a separation means (24) arranged so as to direct a portion (F') of said laser beam (F) towards said generation system (1) and another portion (F") towards said probe system (3), and
- the equipment comprises at least a delay means (25), the delay means (25) being arranged on the path of one of said portions (F'F") of said laser beam (F) so as to synchronize said generator and said probe system (3) with each other.

9. The optoelectronic pump-probe equipment according to claim 8, wherein the light beams (F3, F4) from the generator (10) and the probe system (3) are directed towards a same target (4).

10. The optoelectronic pump-probe equipment according to any one of claims 8 or 9, wherein the probe system (3) comprises non-linear broadband conversion means (31).

11. The optoelectronic pump-probe equipment according to any one of claims 8 to 10, wherein the probe system (3) comprises imaging means (32).

12. The optoelectronic pump-probe equipment according to claim 11, wherein said imaging means (32) are non-linear CARS type imaging means.

13. The optoelectronic pump-probe equipment according to claim 11, wherein said imaging means (32) are second harmonic generation-based non-linear type imaging means.

14. The electro optic pump-probe equipment according to claim 11, wherein said imaging means (32) are fluorescence-based non-linear type imaging means.

## Patentansprüche

1. Hochspannungspulsgenerator, welcher ein Hochspannungspulserzeugungssystem (1) für eingefrorene Wellen und ein Trigger-System (2) für Pulse umfasst, wobei das Erzeugungssystem (1) ein erstes (14) und ein zweites (15) Photoleiterelement aufweist, **dadurch gekennzeichnet, dass** das Trigger-System (2) Mittel (21) zur Erzeugung eines Laserstrahlbündels (F) und Mittel (22, 23) zur Teilung des Laserstrahls (F) in zwei Laserstrahlteile (F1, F2) aufweist, wobei jeder Laserstrahlteil (F1, F2) entsprechend auf ein Photoleiterelement (14, 15) des Erzeugungssystems (1) gerichtet ist, wobei die Mittel (22, 23) zur Teilung eingerichtet sind, die Verteilung der entsprechenden Leistungen der beiden Laserstrahlteile (F1, F2) in Abhängigkeit von der Orientierung der Polarisation des Laserstrahls (F) zu steuern.

2. Hochspannungspulsgenerator nach Anspruch 1, bei dem die Mittel (22, 23) zur Teilung ein Phasenverzögerungsmittel (22) zur linearen Polarisation und ein Mittel (23) zur linearen Polarisation durch Strahlteilung umfassen, das derart eingerichtet ist, dass der Laserstrahl in zwei Teile (F1, F2) getrennt wird, wobei jeder Laserstrahlteil (F1, F2) entsprechend auf ein Photoleiterelement (14, 15) des Erzeugungssystems (1) gerichtet ist, wobei die Verteilung der entsprechenden Leistungen der beiden Laserstrahlteile (F1, F2) durch Orientierung des Phasenverzögerungsmittels (22) zur linearen Polarisation gesteuert wird.

3. Hochspannungspulsgenerator nach Anspruch 2, bei welchem das Phasenverzögerungsmittel (22) zur linearen Polarisation ein Lambda-Halbe-Plättchen ist, dessen optische Achse senkrecht zur Peilrichtung des Laserstrahls (F) ist.

4. Hochspannungspulsgenerator nach irgendeinem der Ansprüche 2 oder 3, bei dem das Mittel (23) zur linearen Polarisation durch Strahlteilung ein Polarisator des Wollaston-Typs ist.

5. Hochspannungspulsgenerator nach irgendeinem der vorhergehenden Ansprüche, bei dem das Trigger-System (2) für Pulse auch ein Fokussiermittel (26) aufweist, das vor dem Mittel (23) zur linearen Polarisation durch Strahlteilung derart angeordnet ist, dass jeder Laserstrahlteil (F1, F2) entsprechend auf ein Photoleiterelement (14, 15) des Erzeugungssystems (1) fokussiert wird.

6. Hochspannungspulsgenerator nach irgendeinem der vorhergehenden Ansprüche, bei dem die Mittel (21) zur Erzeugung des Laserstrahls (F) vom Typ eines Mikrolasers sind.

7. Anordnung mehrerer Hochspannungspulsgeneratoren, die N Hochspannungspulsgeneratoren umfassen, wobei N eine Zahl größer oder gleich 2 ist, wobei jeder Generator ein Hochspannungspulserzeugungssystem für eingefrorene Wellen (1, 1') und ein Trigger-System (2, 2') für Pulse aufweist, wobei das Erzeugungssystem (1, 1') ein erstes (14, 14') und ein zweites (15, 15') Photoleiterelement umfasst, **dadurch gekennzeichnet, dass**:
- das Trigger-System (2, 2') jedes Generators Mittel (22, 22', 23, 23') zur Teilung des Laserstrahls (F', F") in zwei Laserstrahlteile (F'1, F"1, F'2, F"2) umfasst, wobei jeder Laserstrahlteil (F'1, F"1, F'2, F"2) entsprechend auf ein Photoleiterelement (14, 14', 15, 15') des Erzeugungssystems (1, 1') gerichtet ist, wobei die Mittel (22, 22', 23, 23') zur Teilung eingerichtet sind, die Verteilung der entsprechenden Leistungen der beiden Laserstrahlteile (F'1, F"1, F'2, F"2) in Abhängigkeit von der Orientierung der Polarisation des Laserstrahls (F, F') zu steuern,
- das Trigger-System (2) eines der N Generatoren Mittel (21) zur Erzeugung des Laserstrahls (F) aufweist,
- das Trigger-System (2) von zumindest N-1 Generatoren zumindest ein Verzögerungsmittel aufweist, das eingerichtet ist, die Generatoren untereinander zu synchronisieren, und
- jeder Generator ein Teilungsmittel (24, 24') aufweist, das eingerichtet ist, einen Teil des Laserstrahls (F), der durch die Mittel (21) zur Erzeugung auf die Mittel (22, 22', 23, 23') zur Teilung des Generators ausgesandt wird, zu lenken.

8. Elektrooptisches Pump-Probe-Gerät, das einen Hochspannungspulsgenerator und ein Probe-System (3) umfasst, wobei der Generator ein Hochspannungspulserzeugungssystem (1) für eingefrorene Wellen und ein Trigger-System für Pulse (2) umfasst, wobei das Erzeugungssystem (1) ein erstes (14) und ein zweites (15) Photoleiterelement aufweist, **dadurch gekennzeichnet, dass**:
- das Trigger-System (2) Mittel (21) zur Erzeugung eines Laserstrahlbündels (F) und Mittel (22, 23) zur Teilung des Laserstrahls (F) in zumindest zwei Laserstrahlteile (F1, F2) aufweist, wobei jeder Laserstrahl (F1, F2) entsprechend auf ein Photoleiterelement (14, 15) des Erzeugungssystems (1) gerichtet ist, wobei die Mittel (22, 23) zur Teilung eingerichtet sind, die Verteilung der entsprechenden Leistungen der zumindest zwei Laserstrahlteile (F1, F2) in Abhängigkeit von der Orientierung der Polarisation des Laserstrahls (F) zu steuern,
- der Generator ein Teilungsmittel (24) aufweist, das eingerichtet ist, einen Teil (F') des Laserstrahls (F) auf das Erzeugungssystem (1) und einen anderen Teil (F") auf das Probe-System (3) zu richten, und
- das Gerät zumindest ein Verzögerungsmittel (25) aufweist, wobei ein Verzögerungsmittel (25) auf der Strecke eines der Teile (F', F") des Laserstrahls (F) angeordnet ist, um den Generator und das Probe-System (3) untereinander zu synchronisieren.

9. Elektrooptisches Pump-Probe-Gerät nach Anspruch 8, bei dem die vom Generator (10) und vom Probe-System (3) ausgesandten Strahlbündel (F3, F4) auf ein gemeinsames Ziel (4) gerichtet sind.

10. Elektrooptisches Pump-Probe-Gerät nach irgendeinem der Ansprüche 8 oder 9, bei dem das Probe-System (3) nicht lineare Konversionsmittel mit großer Bandbreite (31) aufweist.

11. Elektrooptisches Pump-Probe-Gerät nach irgendeinem der Ansprüche 8 bis 10, bei dem das Probe-System (3) Bildgebungsmittel (32) aufweist.

12. Elektrooptisches Pump-Probe-Gerät nach Anspruch 11, bei dem die Bildgebungsmittel (32) nicht lineare CARS sind.

13. Elektrooptisches Pump-Probe-Gerät nach Anspruch 11, bei dem die Bildgebungsmittel (32) durch Erzeugung einer zweiten Harmonischen vom nicht linearen Typ sind.

14. Elektrooptisches Pump-Probe-Gerät nach Anspruch 11, bei dem die Bildgebungsmittel (32) durch Fluoreszenz vom nicht linearen Typ sind.
